(19) Europäisches Patentamt / European Patent Office / Office européen des brevets

(11) **EP 1 786 029 A1**

(12) **EUROPEAN PATENT APPLICATION**
published in accordance with Art. 158(3) EPC

(43) Date of publication:
**16.05.2007 Bulletin 2007/20**

(51) Int Cl.:
**H01L 21/314** (2006.01)    **H01L 21/31** (2006.01)
**H01L 21/768** (2006.01)

(21) Application number: **05780931.1**

(22) Date of filing: **25.08.2005**

(86) International application number:
**PCT/JP2005/015407**

(87) International publication number:
**WO 2006/022319 (02.03.2006 Gazette 2006/09)**

(84) Designated Contracting States:
**DE FR IT NL**

(30) Priority: **25.08.2004 JP 2004245700**
**03.08.2005 JP 2005225717**

(71) Applicants:
- **TOKYO ELECTRON LIMITED**
  **Minato-ku,**
  **Tokyo 107-8481 (JP)**
- **Taiyo Nippon Sanso Corporation**
  **Shinagawa-ku,**
  **Tokyo 1428558 (JP)**
- **OHMI, Tadahiro**
  **Sendai-shi,**
  **Miyagi 980-0813 (JP)**

(72) Inventors:
- **Kobayashi, Yasuo**
  **Nirasaki-shi, Yamanashi 4070192 (JP)**
- **Nishizawa, Kenichi**
  **Kikuchi-gun, Kumamoto 8691101 (JP)**
- **KAMESHIMA, Takatoshi**
  **6820024 (JP)**
- **Isaki, Ryuichiro**
  **Shinagawa-ku, Tokyo 1428558 (JP)**
- **Shinriki, Manabu**
  **Shinagawa-ku, Tokyo 1428558 (JP)**

(74) Representative: **Liesegang, Eva**
**Forrester & Boehmert,**
**Pettenkoferstrasse 20-22**
**80336 München (DE)**

(54) **PLASMA FILM-FORMING METHOD AND APPARATUS THEREFOR**

(57) A fluorine-containing carbon film excellent in heat stability is formed by using $C_5F_8$ gas having a moisture content of $60 \times 10^{-9}$ volume ratio or below. A purifier 2 packed with particles having hydrophilic or reducing surface layers is placed in a gas supply line connecting a process gas source 1 for supplying $C_5F_8$ gas and a film deposition unit 3 for depositing a fluorine-containing carbon film on a substrate by using a plasma produced by ionizing $C_5F_8$ gas. $C_5F_8$ gas is passed through the purifier 2 to remove moisture from the $C_5F_8$ gas. The $C_5F_8$ gas supplied to the film deposition unit 3 to deposit a fluorine-containing carbon film has a moisture content on the order of $20 \times 10^{-9}$ volume ratio. A fluorine-containing carbon film thus deposited contains a very small amount of moisture. Consequently, desorption of fluorine due to moisture contained in the fluorine-containing carbon film when the fluorine-containing carbon film is heated by a subsequent heating process is not likely to occur and the fluorine-containing carbon film has high heat stability.

FIG. I

EP 1 786 029 A1

**Description**

TECHNICAL FIELD

The present invention relates to a plasma-assisted deposition method of forming a fluorine-containing carbon film (fluorocarbon film) to be used as, for example, a layer insulating film or the like, and a plasma-assisted deposition system for carrying out the plasma-assisted deposition method.

BACKGROUND ART

A technique for forming a multilevel wiring structure is one of methods for increase the level of integration. In a multilevel wiring structure, the n-th wiring layer and the n+1-th wiring layer are connected by a conductive layer embedded in a thin film called a layer insulating film. Silicon dioxide films ($SiO_2$ films) are representative layer insulating films. It has been requested to reduce the dielectric constant of the layer insulating film for the further enhancement of the operating speed of a device.

A fluorine-containing carbon film (hereinafter referred to simply as "CF firm"), namely, a film of a compound of carbon (C) and fluorine (F), has become widely noticed to meet such a request. A CF film has a dielectric constant far smaller than that of a silicon dioxide film. A CF film is formed by producing active species by ionizing a source gas containing C and F and making the active species react. Well known as a source gas is $C_4F_8$ gas. Products obtained by decomposing $C_5F_8$ gas can easily form a three-dimensional structure. Consequently, a layer insulating film having strong C-F bonds can be formed. Such a layer insulating film has a small dielectric constant and excellent heat stability.

A film deposition technique disclosed in Patent document 1 uses cyclic $C_5F_8$ gas as a source gas, ionizes a plasma producing gas, such as Ar gas, by causing electron cyclotron resonance through the interaction of a microwave of 2.45 GHz and a magnetic field of 875 G, ionizes $C_5F_8$ gas by the plasma and deposits a CF film on a semiconductor wafer (hereinafter referred to simply as "wafer").

Patent document 1: JP 11-162960 A

DISCLOSURE OF THE INVENTION

Problem to be Solved by the Invention

A source gas contains moisture. For example, a source gas contained in a gas cylinder has a moisture content below a lower limit of moisture content measurable by the Karl Fischer method. Therefore, the moisture content of a source gas contained in a gas cylinder could not have accurately been determined. If a CF film is formed by using a $C_5F_8$ gas containing an unmeasurebly small amount of moisture, the CF film contains water molecules ($H_2O$ molecules). If a CF film contains water molecules, hydrogen atoms (H) derived from the water molecules and fluorine atoms (F) bond together to produce hydrogen fluoride (HF). When the CF film is heated at temperatures not lower than 350°C during a semiconductor device fabricating process, the HF comes off the CF film. In other words, F evaporates and comes off the CF film when the CF film is heated. Consequently, the heat stability of the CF film deteriorates. When F thus evaporates during a heating process, voids are formed in the CF film, and the CF film becomes brittle. Consequently, the adhesion of the CF film to the adjacent film deteriorates, a laminated structure including the layer insulating film is likely to delaminate, the effect of layer insulating film for holding down wiring lines is reduced, the wiring lines are likely to meander, electromigration is likely to occur and there is the possibility that the wiring lines are corroded by hydrogen fluoride produced in the layer insulating film.

The present invention has been made in view of the foregoing problems and it is therefore an object of the present invention to provide a plasma-assisted deposition method of forming a CF film having excellent heat stability by ionizing $C_5F_8$ gas, and a plasma-assisted deposition system for carrying out the plasma-assisted deposition method.

Means for Solving the Problem

A plasma-assisted deposition method according to the present invention is characterized by depositing a CF film by using a plasma produced by ionizing $C_5F_8$ gas having a moisture content of $60 \times 10^{-9}$ volume ratio or below. Another plasma-assisted deposition method according to the present invention is characterized by depositing a CF film by using plasma produced by ionizing $C_5F_8$ gas obtained by passing $C_5F_8$ gas containing moisture through a purifier packed with particles of a substance having hydrophilic or reducing surface layers. The dry $C_5F_8$ gas dried by the purifier has, for example, a moisture content of $60 \times 10^{-9}$ volume ratio or below.

A plasma-assisted deposition system according to the present invention includes: a $C_5F_8$ gas source; a film deposition unit for depositing a CF film on a substrate by using a plasma produced by ionizing $C_5F_8$ gas; a source gas supply line connecting the $C_5F_8$ gas source to the film deposition unit to supply $C_5F_8$ gas to the film deposition unit; and a purifier packed with particles of a substance having hydrophilic or reducing surface layers and placed in the source gas supply line. Preferably, the purifier is disposed with its gas outlet positioned near the gas inlet of the film deposition unit. The purifier removes moisture from $C_5F_8$ gas to supply $C_5F_8$ gas having a moisture content of $60\times10^{-9}$ volume ratio or below to the film deposition unit.

Effect of the Invention

According to the present invention, a CF film is formed by using a plasma produced by ionizing $C_5F_8$ gas having a moisture content of $60\times10^{-9}$ volume ratio or below and hence the CF film contains a very small amount of moisture. Therefore, the desorption of fluorine from the CF film occurs scarcely when the CF film is heated in the subsequent process due to moisture contained in the CF film and hence the CF film has high heat stability.

According to the present invention, $C_5F_8$ gas passed through the purifier is supplied into the film deposition unit. Therefore, the moisture content of $C_5F_8$ gas passed through the purifier can be kept substantially constant even if the moisture content of $C_5F_8$ gas supplied to the purifier is unstable due to the variation of the vapor pressure of moisture in a gas phase contained in the gas cylinder caused by temperature variation. Thus $C_5F_8$ gas having a stable moisture content can be supplied into the film deposition unit.

According to the present invention, the purifier is disposed with its gas outlet positioned near the gas inlet of the film deposition unit. Therefore, even if moisture adheres to the inside surface of the gas supply line extending between the purifier and the film deposition unit, the influence of the moisture adhering to the inside surface of the gas supply line can be limited to the least extent and $C_5F_8$ gas having a stable moisture content can be supplied to the film deposition unit.

BRIEF DESCRIPTION OF THE DRAWINGS

Fig. 1 is a schematic view of a plasma-assisted deposition system in a preferred embodiment according to the present invention for carrying out a plasma-assisted deposition method according to the present invention;

Fig. 2 is a sectional view of a purifier and a film deposition unit included in the plasma-assisted deposition system shown in Fig. 1;

Fig. 3 is a typical sectional view of a semiconductor device provided with a layer insulating film of fluorine-containing carbon;

Fig. 4 is a plan view of a second gas supply unit included in the film deposition unit shown in Fig. 2;

Fig. 5 is a partly cutaway perspective view of an antenna unit included in the film deposition unit shown in Fig. 2;

Fig. 6 is a diagram showing results of the TDS analysis of CF films formed respectively by using $C_5F_8$ gases respectively having different moisture contents; and

Fig. 7 is a diagram showing results of the TSD analysis of CF films formed respectively by using $C_5F_8$ gases respectively having different moisture contents.

BEST MODE FOR CARRYING OUT THE INVENTION

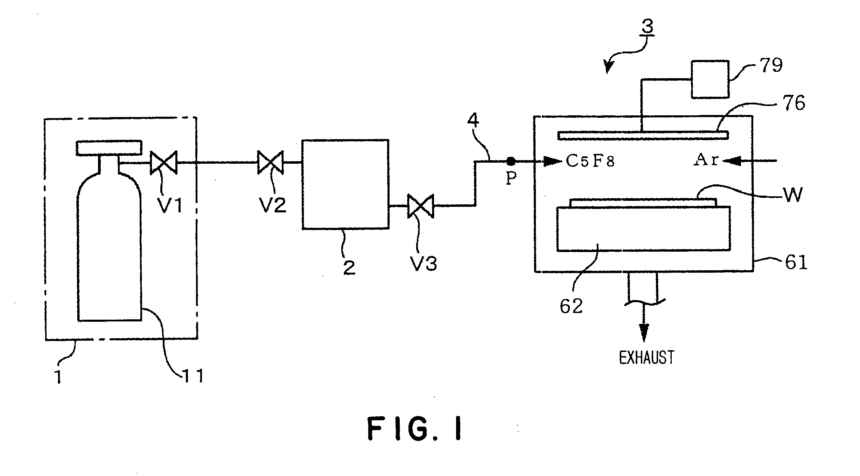

A plasma-assisted deposition system in a preferred embodiment according to the present invention will be described as applied to depositing a CF film to be used as a layer insulating film. Fig. 1 shows the construction of a plasma-assisted deposition system. The plasma-assisted deposition system deposits a CF film on a substrate, such as a semiconductor wafer (hereinafter referred to simply as "wafer") W on which an integrated circuit including CMOS circuits is formed.

Referring to Fig. 1, a process gas source 1 is provided with a gas container 11 containing a source gas. The source gas is, for example, $C_5F_8$ gas having a moisture content of $100\times10^{-9}$ volume ratio (100 ppb) or below, such as a moisture content on the order of $60\times10^{-9}$ volume ratio (60 ppb). The source gas may be cyclic $C_5F_8$ gas (1,2,3,3,4,4,5,5-octafluoro-1-cyclopentene), $C_5F_8$ gas having one triple bond (1,3,3,4,4,5,5,5-octafluoro-1-pentyne) or $C_5F_8$ gas having conjugated double bonds (1,1,2,3,4,5,5,5-octafluoro-1,3-pentadiene).

The moisture content of the source gas is expressed in volume ratio, which is calculated by using the following expression.

$$\text{(Volume of } H_2O)/\text{(Volume of source gas)}$$
$$= \text{(Volume of } H_2O)/\text{(Volume of } C_5F_8 \text{ gas + volume of } H_2O)$$

A purifier 2 is disposed on the downstream side of the gas container 11. The purifier 2 removes moisture from the source gas by means of particles of a substance capable of selectively adsorbing moisture to provide $C_5F_8$ gas having a low moisture content on the order of $20 \times 10^{-9}$ volume ratio (20 ppb). The following description will be made on an assumption that the gas container 11 contains $C_5F_8$ gas having a moisture content on the order of $60 \times 10^{-9}$ volume ratio as a source gas, and $C_5F_8$ gas having a moisture content on the order of $20 \times 10^{-9}$ volume ratio provided by the purifier 2 by removing moisture from the source gas is used for film deposition.

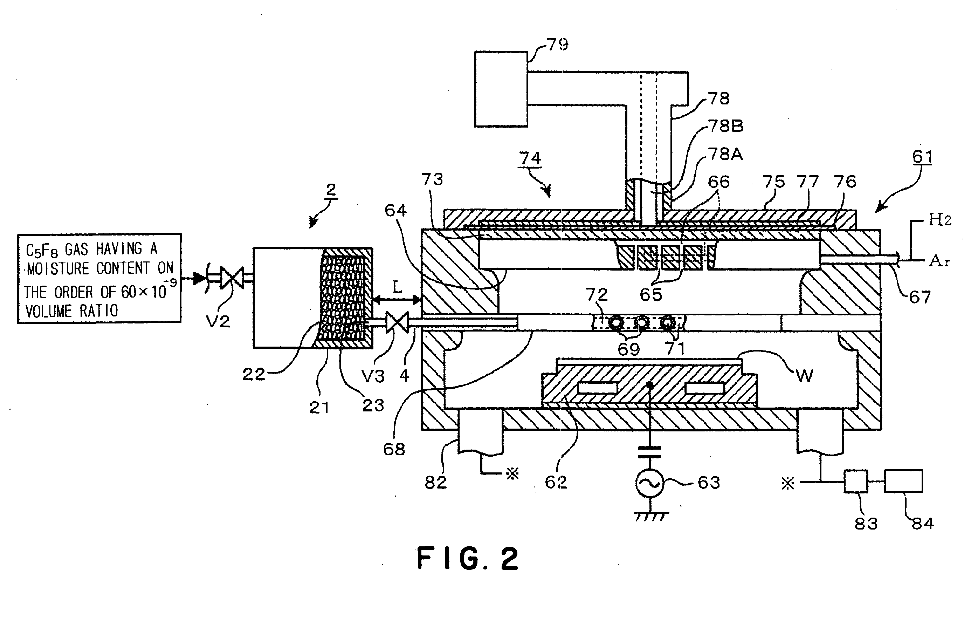

Referring to Fig. 2, the purifier 2 is packed with porous pellets 22 of, for example, zeolite, silica, alumina or a metal oxide, having a 2~3mm average particle size. The pellets are processed by a predetermined activation process and have hydrophilic or reducing surface layers.

The purifier 2 has a purifier container 21. The source gas supplied to the purifier 2 flows downstream through gaps between the pellets 22. When the source gas comes into contact with the hydrophilic or reducing surface layers of the pellets 22, moisture contained in the source gas is removed from the source gas by chemical adsorption by the surfaces of the pellets 22. Thus the purifier 2 removes moisture from $C_5F_8$ gas having a moisture content on the order of $60 \times 10^{-9}$ volume ratio to provide $C_5F_8$ gas having a moisture content on the order of $20 \times 10^{-9}$ volume ratio.

A film deposition unit 3 is disposed on the downstream side of the purifier 2. The film deposition unit 3 ionizes the source gas dried and provided by the purifier 2 to deposit a CF film on a wafer W. In the film deposition unit 3, the wafer W is placed on a stage 62. A plane antenna plate 76, such as a radial line slot antenna, is disposed above and opposite to the stage 62. The source gas and Ar gas, namely, a carrier gas, are supplied into a space between the stage 62 and the plane antenna plate 76 and a microwave is applied to the plane antenna plate 76 by a microwave generator 79 to ionize the source gas by the microwave. a CF film is deposited by the plasma. As shown in Figs. 1 and 2, a valve V1 is placed in a supply line connected to the gas container 11, valves V2 and V3 are placed in a supply line 4 connected to the inlet and the outlet of the purifier 2.

The gas container 11, the purifier 2, and a gas discharge device 68 included in the film deposition unit 3 shown in Fig. 2 are connected by the supply line 4. The purifier 2 is disposed near the gas discharge device 68 of the film deposition unit 3. Although there are not particular restrictions on the position of the purifier 2, it is preferable to dispose the purifier 2 near the gas discharge device 68 because moisture adhering to the inside surface of a pipe extending downstream from the purifier flows into the film deposition unit 3 or the moisture flies out of the pipe base material, for example, at the initial stage of operation of the film deposition unit 3 if the purifier 2 is remote from the film deposition unit 3.

An actual distance implied by the word "near" may be dependent on the construction of the plasma-assisted deposition system including the film deposition unit 3. Preferably, the purifier 2 is disposed as near to the film deposition unit 3 as possible. It is preferable, for example, to connect the purifier 2 directly to the gas inlet of the film deposition unit 3. Generally, in a semiconductor device manufacturing plant, a gas box including the gas cylinder and the film deposition unit 3 are a considerably long distance apart, and a gas supply control system including devices, such as valves and flow meters, is placed in a line connecting the gas box and the film deposition unit 3. It is considered that the purifier 2 is disposed near the film deposition unit 3 when the purifier 2 is nearer to the film deposition unit 3 than the gas supply control system.

When the valves V1, V2 and V3 are opened after evacuating a chamber 61 included in the film deposition system 3 of the plasma-assisted deposition system to a predetermined pressure, $C_5F_8$ gas contained in the gas vessel 11 and containing moisture at a moisture content on the order of $60 \times 10^{-9}$ volume ratio flows through the purifier 2 into the film deposition unit 3. The purifier 2 removes moisture from the $C_5F_8$ gas by chemical adsorption while the $C_5F_8$ gas is passing through the purifier 2. Therefore, $C_5F_8$ gas that flows into the film deposition unit 3 has a very low moisture content on the order of $20 \times 10^{-9}$ volume ratio. The $C_5F_8$ gas having such a low moisture content supplied into the film deposition unit 3 is activated by an Ar plasma and a CF film is deposited on the wafer W.

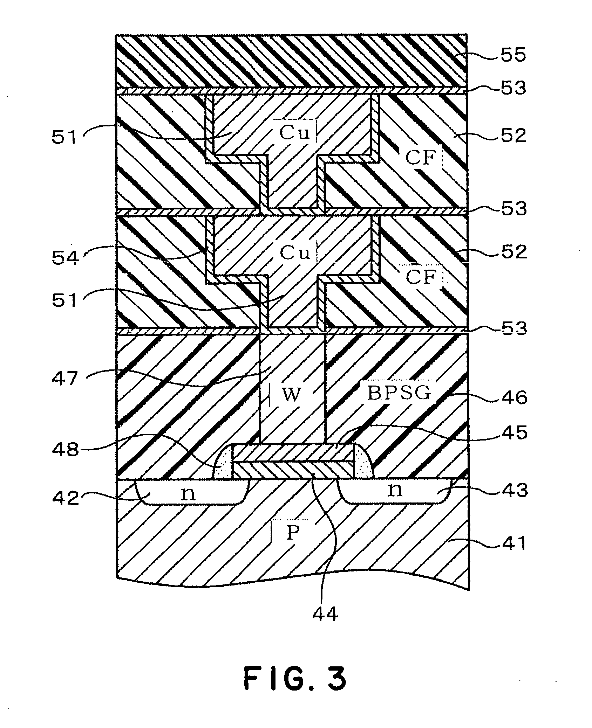

Fig. 3 shows a semiconductor device provided with a layer insulating film, namely, the CF film formed by the plasma-assisted deposition system by way of example. The semiconductor device shown in Fig. 3 has a MOS transistor including a p-type silicon layer 41, n-type regions 42 and 43 serving as a source and a drain, respectively, a gate oxide film 44, and a gate electrode 45. Shown also in Fig. 3 are a BPSG film 46, namely a silicate glass film doped with boron (B) and phosphor (P), a wiring line 47 of tungsten (W) and a side spacer 48. Layer insulating films 52, namely, CF films (CF films) are formed in layers and wiring layers 54 of, for example, copper are embedded in the layer insulating films 52. In Fig. 3, the number of the layer insulating film 52 is two. Indicated at 53 are hard masks of, for example, silicon nitride or silicon carbide containing nitrogen (SiCN), at 54 are protective layers of, for example, titanium nitride or tantalum nitride for preventing the diffusion of a metal forming the4 wiring lines and at 55 is a protective film.

Processes for fabricating the semiconductor device includes thermal processes that heat the wafer. The thermal processes heat the layer insulating films 52 at process temperatures. The thermal processes are, for example, an insulating film forming process, a copper wiring line annealing process and a hard mask annealing process for annealing the hard mask, such as a tantalum nitride film. The highest process temperature to which the layer insulating films 52 are exposed in the thermal processes is, for example, in the range of 350°C to 420°C. Process temperatures of the thermal processes are expected to decrease as the miniaturization of semiconductor devices makes progress.

The plasma-assisted deposition system in this embodiment includes the purifier 2 packed with the pellets having the hydrophilic or reducing surface layers. The pellets remove moisture contained in a small moisture content in the source gas by chemical adsorption. Consequently, the moisture content of the $C_5F_8$ gas can be reduced to about $20 \times 10^{-9}$ volume ratio.

A moisture detecting method used for examining the effect of the purifier 2 will be briefly described. A quartz oscillation method and the Karl Fischer method have been used to measure the moisture content of a CF gas, namely, a compound of F and C. Those methods cannot measure moisture contents of $6000 \times 10^{-9}$ volume ratio or below. The inventors of the present invention established a moisture content measuring method using an infrared laser absorption spectroscopy and capable of measuring a moisture content of $100 \times 10^{-9}$ volume ratio or below of a CF gas. The infrared laser absorption spectroscopy projects a light beam of 1392.53 nm in wavelength emitted by an infrared laser on a test sample, detects the light beam penetrated the test sample and calculates a moisture content on the basis of time needed for the intensity of the detected light beam to reach a threshold by using Lambert's expression. When moisture content is measured by this moisture content measuring method, minimum limit of detection $3\sigma = 9 \times 10^{-9}$ volume ratio and minimum limit of determination $10\sigma$ is on the order of $20 \times 10^{-9}$ volume ratio, in which "$\sigma$" is an indicator of the dispersion of noise. The moisture content of $C_5F_8$ gas contained in a gas cylinder measured by this moisture content measuring method was on the order of $100 \times 10^{-9}$ volume ratio.

Since the small moisture content of $100 \times 10^{-9}$ volume ratio or below of the CF gas can be accurately measured by this moisture content measuring method, it could be found that a small amount of moisture contained in $C_5F_8$ gas in a very small moisture content of $100 \times 10^{-9}$ volume ratio or below affects greatly the heat stability of a CF film formed by using the $C_5F_8$ gas. The inventors of the present invention conducted experiments using $C_5F_8$ gas having a moisture content of $100 \times 10^{-9}$ volume ratio or below and found that it is very effective to use $C_5F_8$ gas having a moisture content of $60 \times 10^{-9}$ volume ratio or below for forming a CF film in improving the heat stability of the CF film. The present invention is based on such a finding.

Heat stability is ability to suppress the desorption of fluorine-containing gases, such as hydrogen fluoride and fluorine carbide, from the CF film when the CF film is heated. A CF film having a small moisture content has a small amount of hydrogen that will be bonded with fluorine contained in the CF film. Therefore, the amount of fluorine contained in hydrogen fluoride removed from the CF film is small when the CF film is heated. When the amount of fluorine removed by the degassing effect of the thermal process is thus reduced, formation of voids in the film can be suppressed, reduction of adhesion can be suppressed, separation of the film can be prevented, reduction of the effect of the layer insulating film in holding down the wiring lines can be suppressed, and meandering of the wiring lines and occurrence of electromigration in the wiring lines can be prevented.

The amount of fluorine-containing gases, such as hydrogen fluoride and fluorine carbide, desorbed from a CF film formed by using $C_5F_8$ gas having a moisture content on the order of $60 \times 10^{-9}$ volume ratio when the CF film was heated was smaller than that of fluorine-containing gases desorbed from a CF film formed by using $C_5F_8$ gas having a moisture content on the order of $100 \times 10^{-9}$ volume ratio when the CF film was heated. It was found that the amount of fluorine-containing gases desorbed from a CF film formed by using $C_5F_8$ gas having a moisture content on the order of $20 \times 10^{-9}$ volume ratio was furthermore small. It was found that properties of CF films deposited by using $C_5F_8$ gas having a moisture content of $60 \times 10^{-9}$ volume ratio, preferably, a moisture content on the order of $20 \times 10^{-9}$ volume ratio were not degraded even if the CF films were heated in the subsequent processes at temperatures on the order of 350°C. Thus it is understood that such CF films are optimum insulating films, such as layer insulating films.

The purifier 2 is interposed between the process gas source 1 and the film deposition unit 3. Therefore, $C_5F_8$ gas having a moisture content on the order of $20 \times 10^{-9}$ volume ratio can be stably supplied into the film deposition unit 3. In some cases, the moisture content of $C_5F_8$ gas is made unstable on the upstream side of the purifier 2 by the variation of the vapor pressure of moisture in the gas phase contained in the gas container 11 due to temperature variation. For example, the gas container contains both gas phase $C_5F_8$ and liquid-phase $C_5F_8$. Therefore, the moisture content of the gas-phase $C_5F_8$ changes with temperature variation. Respective rate of change of an $H_2O$ vapor pressure curve and a $C_5F_8$ vapor pressure curve with temperature are different. Therefore, in a temperature range, the moisture content of the gas phase changes and the $H_2O/C_5F_8$ ratio of the atmosphere in the gas container 11 changes. Therefore, even if the moisture content of the $C_5F_8$ gas contained in the gas container 11 is $60 \times 10^{-9}$ volume ratio or below in a predetermined temperature range, the moisture content becomes $60 \times 10^{-9}$ volume ratio or above in some cases at temperatures outside the predetermined temperature range. Thus the moisture content of the $C_5F_8$ gas is likely to change with temperature if the purifier 2 is not used.

Moisture contained in the source gas is removed from the source gas by chemical adsorption by the hydrophilic or reducing surface layers of the pellets 22 packed in the purifier 2 when the source gas is passed through the purifier 2. Consequently, the $C_5F_8$ gas passed through the purifier 2 has a substantially fixed moisture content regardless of the moisture content of the $C_5F_8$ gas to be passed through the purifier 2. Consequently, the $C_5F_8$ gas having a stable moisture content can be always supplied to the film deposition unit 3 and hence the CF film formed by using the $C_5F_8$ gas passed through the purifier 2 has a stable moisture content.

The moisture content of the $C_5F_8$ gas can be always reduced to a moisture content on the order of $20 \times 10^{-9}$ volume ratio by the punifier. Thus the $C_5F_8$ gas having a moisture content on the order of $20 \times 10^{-9}$ volume ratio can be stably supplied to the film deposition unit 3.

It is preferable to dispose the purifier 2 near the film deposition unit 3. The supply line 4 is, for example, a pipe having an inside surface finished by chemical polishing. the length of a part of the supply line 4 connecting the purifier 2 to the film deposition unit 3 is short when the purifier 2 is disposed near the film deposition unit 3. Therefore, even if moisture adheres to the inside surface of that part of the supply line 4, the influence of the moisture can be effectively suppressed and the $C_5F_8$ gas having a stable moisture content can be supplied into the film deposition unit 3.

As mentioned above, the amount of gases degassed from a CF film formed by using $C_5F_8$ gas having a moisture content on the order of $60 \times 10^{-9}$ volume ratio when the CF film is heated is smaller than that of gases degassed from a CF film formed by using $C_5F_8$ gas having a moisture content on the order of $100 \times 10^{-9}$ volume ratio when the CF film is heated. Thus the former CF film has improved thermal stability. According to the present invention, the purifier 2 is not necessarily included in the plasma-assisted deposition system, provided that $C_5F_8$ gas having a moisture content of $60 \times 10^{-9}$ volume ratio below is used for forming a CF film.

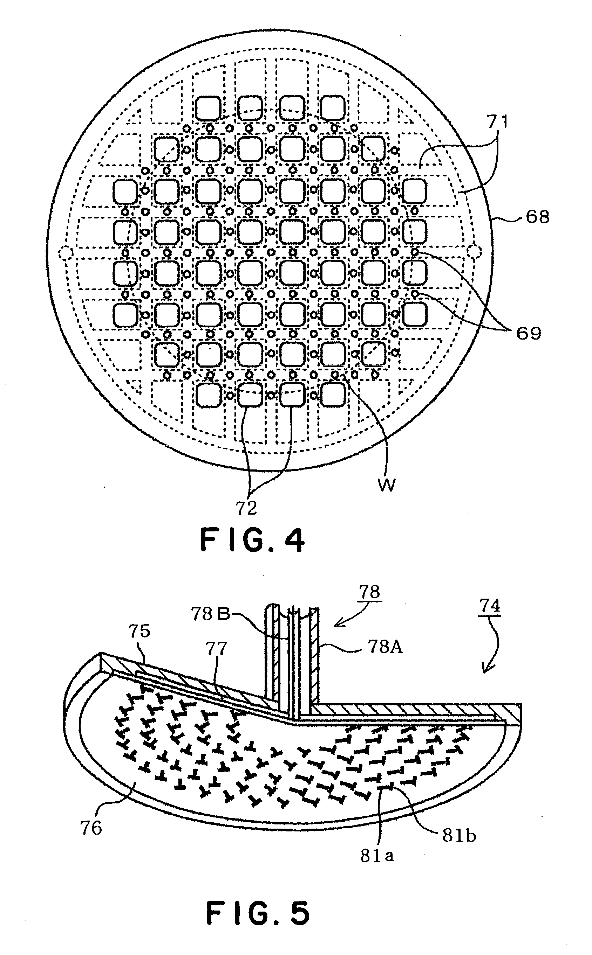

The film deposition unit 3 will be described with reference to Figs. 2 and 4 by way of example. The film deposition unit 3 is a CVD system (chemical vapor deposition system) using a radial line slot antenna for producing a plasma. Shown in Figs. 2 and 4 are a processing vessel (vacuum chamber) 61, a stage 62 provided with a temperature adjusting device, and a bias radio frequency power supply 63 for supplying radio frequency power of 13.56 MHz connected to the stage 62. The stage 62 is provided with an electrostatic chuck.

A first gas discharge device 64 is disposed in an upper part of the processing vessel 61 opposite to the stage 62. The first gas discharge device 64 has a substantially circular shape in a plane. The gas discharge device 64 is made of, for example, aluminum oxide. The gas discharge device 64 has a wall facing the stage 62 and provided with many first gas discharge holes 65. The first gas discharge holes 65 are connected to a first gas supply line 67 by gas passages 66. A plasma gas source for supplying Ar gas or Kr gas and a hydrogen gas source for supplying $H_2$ are connected to the first gas supply line 67.

A second gas discharge device 68 is disposed in a space between the stage 62 and the first gas discharge device 64. The second gas discharge device 68 is substantially circular in a plane. The second gas discharge device 68 is made of a conducting material, such as an aluminum alloy containing magnesium (Mg) or an aluminum-containing stainless steel. The second gas discharge device 68 has a wall facing the stage 62 and provided with many second gas discharge holes 69. As shown in Fig. 4, the second gas discharge device 68 is internally provided with gas passages 71 formed in a grid. The gas passages 71 are connected to inner ends of the gas discharge holes 69. The gas passages 71 are connected to the supply line 4. The second gas discharge device 68 is provided with many through holes 72. A plasma and a source gas contained in the plasma flow down through the through holes 72 into a space extending under the second gas supply device 68. The through holes are formed, for example, between the adjacent gas passages 71.

The second gas supply device 68 is connected through the supply line 4 and the purifier 2 to the gas container 11 containing $C_5F_8$ gas, namely, a source gas. The $C_5F_8$ gas is supplied through the supply line 4 into the gas passages 71 and is discharged through the gas discharge holes 69 so as to be distributed uniformly in the space extending under the second gas discharge device 68.

The upper surface of the first gas discharge device 64 is covered with a cover plate 73 made of a dielectric material, such as aluminum oxide. An antenna 74 is placed in close contact with the upper surface of the cover plate 73. As shown in Fig. 5, the antenna 74 includes a flat, circular antenna body 75 having an open lower end, and a disk-shaped, plane antenna plate (slot plate) 76 covering the open lower end of the antenna body 75 and provided with many slots. The antenna body 75 and the antenna plate 76 are made of a conducting material and form a flat, circular wave guide. The lower surface of the plane antenna plate 76 is in contact with the cover plate 73.

A lagging plate 77 is held between the antenna body 75 and the plane antenna plate 76. The lagging plate 77 is made of a low-loss dielectric material, such as aluminum oxide or silicon nitride ($Si_3N_4$). The lagging plate 77 shortens the wavelength of the microwave to shorten guide wavelength. In this embodiment, the antenna body 75, the plane antenna plate 76 and the lagging plate 77 form a radial line slot antenna (RLSA)

The antenna 74 is closely joined to the processing vessel 61 with a sealing member, not shown, held between the plane antenna plate 76 and the cover plate 73. The antenna 74 is connected to a microwave generator 79 by a coaxial waveguide 78. The microwave generator 79 generates a 2.45 GHz or 8.3 GHz microwave. The coaxial waveguide 78 has an outer cylinder 78A connected to the antenna body 75, and a center conductor 78B extended through an opening formed in the lagging plate 77 and connected to the plane antenna plate 76.

As shown in Fig. 5, the plane antenna plate 76 is, for example, a copper plate of a thickness on the order of 1 mm provided with many T slots 81 for radiating a circularly polarized wave. Each of the T slots 81 is formed by combining slots 81a and 81b in a shape substantially resembling the letter T with a small gap formed between the slots 81a and 81b. The slots 81a and 81b are perpendicular to each other. The T slots 81 are arranged on concentric circles or a spiral. Thus the plane antenna plate 76 radiates a circularly polarized wave including two orthogonal polarization components. The slots 81a and 81b are separated by a space corresponding to the wavelength of a microwave compressed by the lagging plate 77 to radiate a plane microwave from the plane antenna plate 76. An exhaust pipe 82 is connected to the bottom wall of the processing vessel 61. The exhaust pipe 82 is connected through a pressure regulator 83 to a vacuum pump 84, namely, an evacuating means. The interior of the processing vessel 61 can be evacuated at a predetermined pressure by the vacuum pump 84.

A film deposition process to be carried out by the plasma-assisted deposition system will be described by way of example. A wafer W, namely, a substrate, is placed on the stage 62. Then, the interior of the processing vessel 61 is evacuated at a predetermined pressure. Subsequently, a plasma gas, such as Ar gas, is supplied through the first gas supply line 67 to the first gas discharge device 64 at a predetermined flow rate of, for example, 300 sccm and, at the same time, a source gas is supplied through the supply line 4 into the second gas discharge device 68 at a predetermined flow rate of, for example, 150 sccm. The source gas is $C_5F_8$ gas purified at a moisture content on the order of $20 \times 10^{-9}$ volume ratio by the purifier 2. The interior of the processing vessel 61 is maintained at a process pressure of, for example, 60 Pa and the stage 62 is heated such that the temperature of the surface of the stage 62 is 350°C.

The microwave generator 79 generates a 2.45 GHz microwave of 2000 W. The microwave is propagated in the TM mode, the TE mode or the TEM mode through the coaxial waveguide 78 to the plane antenna plate 76 of the antenna 74. During the radial propagation of the microwave from a central part of the plane antenna plate 76 corresponding to the center conductor 78B toward a peripheral part of the plane antenna plate 76, the microwave is radiated through the slots 81a and 81b, the cover plate 73 and the first gas discharge device 64 into the processing space extending under the first gas discharge device 64.

Since the slits 81a and 81b are arranged on concentric circles or a spiral, a circularly polarized wave is radiated uniformly from the plane antenna plate 76. Consequently, an electric field of uniform field strength is created in the processing space and a high-density, uniform plasma is produced over the entire wide processing space by the energy of the microwave. The plasma thus produced flows through the through holes 72 of the second gas discharge device 68 into the processing space extending under the second gas discharge device 68. The $C_5F_8$ gas discharged by the second gas discharge device 68 is ionized by the plasma to produce active species. The active species are deposited on the surface of the wafer W to form a CF film serving as a layer insulating film.

Although the film deposition process has been described as applied to the deposition of a layer insulating film by way of example, the CF film deposited by the film deposition process of the present invention may be used as an insulating film other than the layer insulating film. The plasma-assisted deposition system according to the present invention may be provided with a diode parallel-plate plasma CVD unit or an electron cyclotron resonance CVD unit instead of the deposition unit employing the radial line slot antenna.

Examples

Experiments conducted to prove the effect of the present invention will be described. An experiment for forming a CF film in Example 1 was conducted to measure the moisture content of $C_5F_8$ gas on the downstream side of the purifier 2. Experiments for forming CF films in Examples 2 and 3 were conducted to test the desorption of components of the CF films. Example 4 was conducted to form a CF film for the examination of the adhesion of the CF film.

Example 1

The plasma-assisted deposition system of the present invention was used. $C_5F_8$ gas having a moisture content of $60 \times 10^9$ volume ratio or below contained in the gas container 11 was passed through the purifier 2 to obtain $C_5F_8$ gas having a moisture content on the order of $20 \times 10^9$ volume ratio. The moisture content of the $C_5F_8$ gas purified by the purifier 2 was measured by the infrared laser absorption spectroscopy. The moisture content of the $C_5F_8$ gas measured several times at a measuring point P shown in Fig. 1. All the measured values of moisture content were on the order of $20 \times 10^{-9}$ volume ratio.

It was proved that the purifier 2 could remove moisture from the $C_5F_8$ gas having a moisture content on the order of $60 \times 10^9$ volume ratio to obtain the $C_5F_8$ gas having a moisture content on the order of $20 \times 10^9$ volume ratio.

Example 2

The plasma-assisted deposition system provided with the film deposition unit 3 shown in Fig. 2 was used. $C_5F_8$

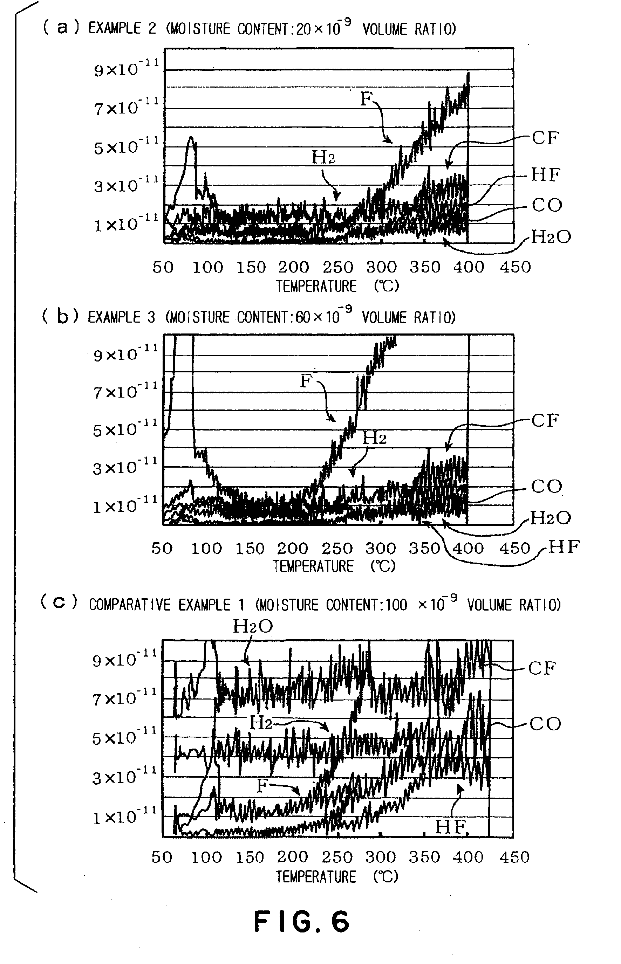

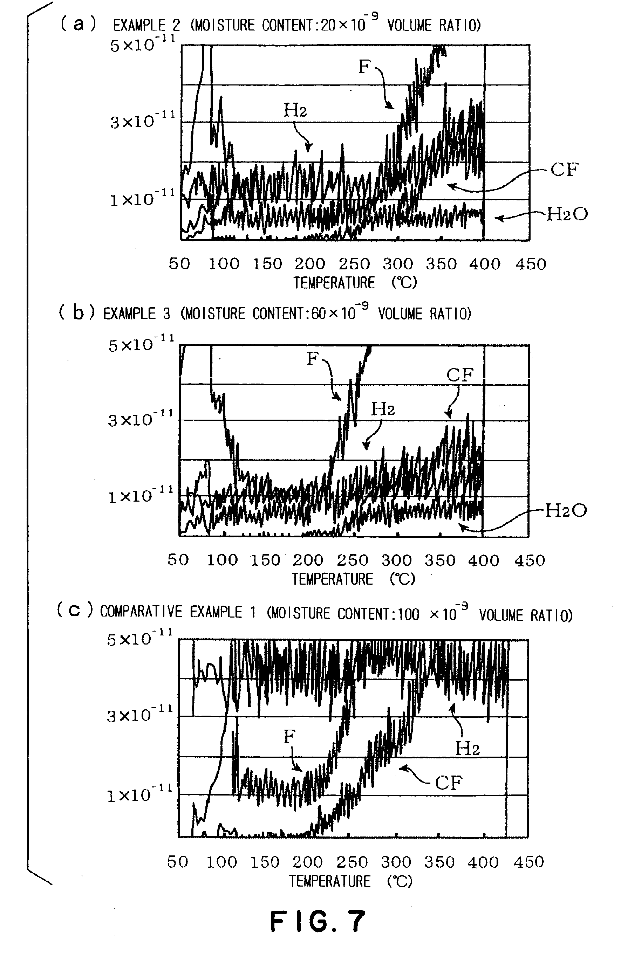

gas having a moisture content on the order of $60 \times 10^9$ volume ratio was passed through the purifier 2 to supply $C_5F_8$ gas having a moisture content on the order of $20 \times 10^9$ volume ratio into the film deposition unit 3. A processing atmosphere in the film deposition unit 3 was maintained at 60 Pa, a microwave of 2000 W was used, the $C_5F_8$ gas was supplied at 200 sccm and Ar gas was supplied at 300 sccm to deposit a fluorine-containing carbon film on an 8 in. wafer W. The length L (Fig. 2) of the pipe connecting the purifier 2 to the gas inlet of the film deposition unit 3 was 1 m. The thickness of the CF film was measured immediately after the deposition of the CF film. Approximately 10 mm square test pieces of the CF films were cut out and the degas composition of the test pieces was measured by TDFS (thermal desorption spectroscopy). The moisture content of the $C_5F_8$ gas measured at the measuring point P near the film deposition unit 3 by an infrared laser absorption spectroscopy was on the order of $20 \times 10^9$ volume ratio. Measured data is shown in Figs. 6(a) and 7(a).

Example 3

The plasma-assisted deposition system used for forming the CF film in Example 2 was used omitting the purifier 2. $C_5F_8$ gas having a moisture content on the order of $60 \times 10^9$ volume ratio was supplied into the film deposition unit 3. A CF film in Example 3 was formed on the same process conditions as Example 2. The degas composition of the CF films was measured by TDS. The moisture content of the $C_5F_8$ gas measured at the measuring point P near the film deposition unit 3 by an infrared laser absorption spectroscopy was on the order of $60 \times 10^9$ volume ratio. Measured data is shown in Figs. 6(b) and 7(b).

Example 4

A nitrogen-containing silicon carbide film (SiCN film), a fluorine-containing carbon film (CF film), a SiCN film and a silicon dioxide film ($SiO_2$ film) were deposited in that order on a bare silicon wafer to obtain a test sample. The test sample was subjected to a tape test.
The upper and the lower SiCN film were identical. The SiCN films were formed in a thickness of 10 nm by the plasma-assisted deposition system provided with the film deposition unit 3 shown in Fig. 2. A microwave of 1500 W and a process pressure of 39.9 Pa (300 mTorr) were used, the wafer was heated at 380°C, trimethylsilane gas was supplied at 40 sccm, Ar gas was supplied at 800 sccm and nitrogen gas was supplied at 50 sccm.
The CF film was formed in a thickness of 120 nm by the plasma-assisted deposition system provided with the film deposition unit 3 shown in Fig. 2. A microwave of 2750 W and a process pressure of 7.4 Pa (56 mTorr) were used, the wafer was heated at 380°C, $C_5F_8$ gas was supplied at 200 sccm and Ar gas was supplied at 250 sccm. The $C_5F_8$ gas had a moisture content on the order of $20 \times 10^{-9}$ volume ratio.
The $SiO_2$ film was formed in a thickness of 40 nm by using a vapor of an organic source, such as TEOS (tetraethylorthosilicate) and oxygen gas. A plasma produced by activating those gases was used to deposit the $SiO_2$ film.
The test sample provided with those laminated films was annealed at 400°C for 1 h, which were process conditions expected to be used by a practical semiconductor device fabricating process. The test sample thus annealed was subjected to a tape test. The tape test scrached a square on the order of 2 mm square in the surface of the test sample, attached a Scotch tape to the scrached part of the test sample, and then peeled off the tape. If adhesion between the adjacent bonded films is insufficient, the bonded films will be separated when a tape attached to the $SiO_2$ film is peeled off. Adhesion between the bonded thin films can be evaluated by the tape test.

Comparative example 1

The purifier was not used. The $C_5F_8$ gas contained in the gas container and having a moisture content on the order of $100 \times 10^{-9}$ volume ratio was supplied into the film deposition unit 3. A CF film in Comparative example 1 was deposited on the same film deposition conditions as those on which the CF film in Example 2 was formed. The CF film in Comparative example 1 was examined by TDS. The moisture content of the $C_5F_8$ gas measured at the measuring point P near the film deposition unit 3 by an infrared laser absorption spectroscopy was on the order of $100 \times 10^9$ volume ratio. Measured data is shown in Figs. 6(c) and 7(c).

Comparative example 2

A CF film in Comparative example 2 was obtained on the same process conditions as those on which the CF film in Example 4 was formed, except that $C_5F_8$ gas having a moisture content on the order of $100 \times 10^{-9}$ volume ratio was used. The CF film in Comparative example 2 was tested similarly to the foregoing test samples.

Results and Examination

In Figs. 6(a), 6(b) and 6(c), temperature is measured on the horizontal axis and the amount of molecules is measured on the vertical axis. The respective amounts of hydrogen ($H_2$), water ($H_2O$), fluorine (F), hydrogen fluorine (HF), carbon monoxide (CO) and carbon fluoride (CF) were determined. Measured amounts of $H_2$, $H_2O$, F, HF CO and CF are shown in combination in Figs. 6(a), 6(b) and 6(c). Figs. 7(a), 7(b) and 7(c) show measured amounts of $H_2$, $H_2O$, F and CF in a scale different from that of Figs. 6(a), 6(b) and 6(c). Values shown in Figs. 6(a), 6(b), 6(c), 7(a), 7(b) and 7(c) were obtained by standardizing (calibrating) measured values on the basis of film thickness and area of test samples.

The respective amounts of $H_2$, $H_2O$, CF, HF and CO desorbed from the CF film in Comparative example 1 were very large as compared with those of $H_2$, $H_2O$, CF, HF and CO desorbed from the CF films in Examples 2 and 3. It is inferred from those measured data that a CF film deposited by using $C_5F_8$ gas having a moisture content on the order of $100 \times 10^{-9}$ volume ratio contains a large amount of $H_2O$, the $H_2O$ contained in the CF film evaporates and $H_2$ and HF are produced due to the decomposition of $H_2O$ when the CF film is heated, the $H_2$ and HF are desorbed from the CF film, the CF film becomes brittle and CF is liable to be desorbed.

The respective amounts of $H_2O$, $H_2$, CF, CO and HF desorbed from the CF films in Examples 2 and 3 are substantially equal and are about a quarter of those desorbed from the CF film in Comparative example 1. Thus, it is known from the measured data that a CF film having high heat stability and capable of reducing the amount of components lost by degassing can be deposited by using $C_5F_8$ gas having a moisture content on the order of $60 \times 10^{-9}$ volume ratio.

Temperature at which the amount of desorbed F starts increasing sharply is the lowest with the CF film in Comparative example 1 and is higher with the CF films in Examples 2 and 3 in order of Examples 3 and 2, and this tendency is the same with CF. This fact proves that the lower the moisture content of the $C_5F_8$ gas, the higher is the temperature at which F is desorbed, the more resistant to the desorption of F is the CF film and also the higher is the heat stability of the CF film.

While the amount of gases desorbed from the CF film in Example 2 starts sharply increasing after the temperature has exceeded 200°C, the amount of gases desorbed from the CF film in Example 3 starts sharply increasing after the temperature has exceeded 250°C. It is inferred that F desorbed at high temperatures is free F contained in the CF film and F desorbed at low temperatures is free F produced by the decomposition of CF film caused by $H_2O$.

The films formed on the silicon wafer and including the CF film in Example 4 formed by using $C_5F_8$ gas having a moisture content on the order of $20 \times 10^{-9}$ volume ratio were not delaminated. A value measured by the four-point bending method (refer to, for example, Engineering Fracture Mechanics pp. 141 - 162 (1998)) was in the range of 4.6 to 5.0 $J/m^2$. It is said that delamination of films occurs scarcely during CMP (chemical mechanical polishing) used by a Cu Damascene fabricating process when a value measured by a four-point bending method is 2.7 $J/m^2$ or above. The value in the range of 4.6 to 5.0 $J/m^2$ is far greater than 2.7 $J/m^2$.

On the other hand, the CF films deposited by using $C_5F_8$ gas having a moisture content on the order of $100 \times 10^{-9}$ volume ratio were peeled off from three sample wafers out of five. Since the SiCN film has a small thickness of 10 nm, it is difficult to specify parts from which the film was peeled off. Peeling occurred in the interface between the CF film and the upper SiCN film or between the upper SiCN film and the $SiO_2$ film. The adhesion value of films on the two sample wafers on which peeling did not occur measured by a four-point bending method was in the range of 2.1 to 2.5 $J/m^2$

Moisture contained in the $C_5F_8$ gas even in a very low moisture content affects the quality of the CF film. Therefore, the control of the moisture content of the $C_5F_8$ gas is important. The inventors of the present invention searched for a method of detecting a very small amount of moisture, studied the relation between a very low moisture content and film quality, and found that the reduction of the moisture content of the $C_5F_8$ gas from $100 \times 10^{-9}$ volume ratio to $60 \times 10^{-9}$ volume ratio improves film quality significantly, and reduction of the moisture content to $20 \times 10^{-9}$ volume ratio further effectively improves film quality.

As mentioned in connection with the description of the background art, a CF film is an effective layer insulating film. Deposition of a CF film of high quality is very difficult. Elucidation of an index of moisture content in the range of very low moisture content is a significant contribution to the practical application of CF films and the present invention is very effective in realizing the practical application of CF films.

**Claims**

1. A plasma-assisted deposition method **characterized by** depositing a fluorine-containing carbon film by using a plasma produced by ionizing $C_5F_8$ gas having a moisture content of $60 \times 10^{-9}$ volume ratio or below.

2. A plasma-assisted deposition method **characterized by** depositing a fluorine-containing carbon film by using a plasma produced by ionizing $C_5F_8$ gas obtained by passing $C_5F_8$ gas containing moisture through a purifier packed with particles of a substance having hydrophilic or reducing surface layers.

**3.** The plasma-assisted deposition method according to claim 2, wherein the $C_5F_8$ gas dried by the purifier has a moisture content of $60 \times 10^{-9}$ volume ratio or below.

**4.** A plasma-assisted deposition system comprising:

a $C_5F_8$ gas source;
a film deposition unit for depositing a fluorine-containing carbon film on a substrate by using a plasma produced by ionizing $C_5F_8$ gas;
a gas supply line connecting the $C_5F_8$ gas source to the film deposition unit to supply $C_5F_8$ gas to the film deposition unit; and
a purifier packed with particles having hydrophilic or reducing surface layers and placed in the source gas supply line.

**5.** The plasma-assisted deposition system according to claim 4, wherein the purifier is disposed with its gas outlet positioned near a gas inlet of the film deposition unit.

**6.** The plasma-assisted deposition system according to claim 4 or 5, wherein the purifier removes moisture from $C_5F_8$ gas supplied to the film deposition unit so that $C_5F_8$ gas has a moisture content of $60 \times 10^{-9}$ volume ratio or below.

FIG. I

EP 1 786 029 A1

C5F8 GAS HAVING A MOISTURE CONTENT ON THE ORDER OF $60 \times 10^{-9}$ VOLUME RATIO

F I G. 2

EP 1 786 029 A1

FIG. 3

# FIG. 4

# FIG. 5

( a ) EXAMPLE 2 (MOISTURE CONTENT:$20 \times 10^{-9}$ VOLUME RATIO)

( b ) EXAMPLE 3 (MOISTURE CONTENT:$60 \times 10^{-9}$ VOLUME RATIO)

( c ) COMPARATIVE EXAMPLE 1 (MOISTURE CONTENT:$100 \times 10^{-9}$ VOLUME RATIO)

F I G. 6

(a) EXAMPLE 2 (MOISTURE CONTENT: $20 \times 10^{-9}$ VOLUME RATIO)

(b) EXAMPLE 3 (MOISTURE CONTENT: $60 \times 10^{-9}$ VOLUME RATIO)

(c) COMPARATIVE EXAMPLE 1 (MOISTURE CONTENT: $100 \times 10^{-9}$ VOLUME RATIO)

# FIG. 7

**INTERNATIONAL SEARCH REPORT**

| International application No. |
| --- |
| PCT/JP2005/015407 |

A. CLASSIFICATION OF SUBJECT MATTER
*H01L21/314* (2006.01), *H01L21/31* (2006.01), *H01L21/768* (2006.01)

According to International Patent Classification (IPC) or to both national classification and IPC

B. FIELDS SEARCHED

Minimum documentation searched (classification system followed by classification symbols)
*H01L21/314* (2006.01), *H01L21/31* (2006.01), *H01L21/768* (2006.01)

Documentation searched other than minimum documentation to the extent that such documents are included in the fields searched
| Jitsuyo Shinan Koho | 1922-1996 | Jitsuyo Shinan Toroku Koho | 1996-2005 |
| Kokai Jitsuyo Shinan Koho | 1971-2005 | Toroku Jitsuyo Shinan Koho | 1994-2005 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| X<br>Y | JP 2001-135633 A (Matsushita Electronics Corp.),<br>18 May, 2001 (18.05.01),<br>Claims; column 7, lines 2 to 14<br>& US 6787445 B1 | 1<br>2-6 |
| Y | JP 10-338506 A (NEC Corp.),<br>22 December, 1998 (22.12.98),<br>Colunm 6, lines 1 to 6<br>& US 6065489 A | 2-6 |
| P,X | WO 2005/017991 A1 (Tokyo Electron Ltd.),<br>24 February, 2005 (24.02.05),<br>Claims<br>(Family: none) | 1 |

| [X] Further documents are listed in the continuation of Box C. | [ ] See patent family annex. |
| --- | --- |

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search<br>27 October, 2005 (27.10.05) | Date of mailing of the international search report<br>08 November, 2005 (08.11.05) |
| --- | --- |
| Name and mailing address of the ISA/<br>Japanese Patent Office | Authorized officer |
| Facsimile No. | Telephone No. |

Form PCT/ISA/210 (second sheet) (April 2005)

**INTERNATIONAL SEARCH REPORT**

| International application No. |
| --- |
| PCT/JP2005/015407 |

C (Continuation).  DOCUMENTS CONSIDERED TO BE RELEVANT

| Category* | Citation of document, with indication, where appropriate, of the relevant passages | Relevant to claim No. |
| --- | --- | --- |
| A | WO 1999/028963 A1  (Nippon Zeon Co., Ltd.), 10 June, 1999 (10.06.99), & TW 425630 A | 1-6 |

Form PCT/ISA/210 (continuation of second sheet) (April 2005)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 11162960 A


**Non-patent literature cited in the description**

- *Engineering Fracture Mechanics,* 1998, 141-162